# EUROPEAN PATENT SPECIFICATION

(11) **EP 2 132 600 B1**
(45) Date of publication and mention of the grant of the patent: **04.01.2012**
(21) Application number: 08719741.4
(22) Date of filing: 17.03.2008
(51) Int. Cl.: G03F 7/20, B23Q 1/62, H01L 21/687

(54) **SPLIT AXES STAGE DESIGN FOR SEMICONDUCTOR APPLICATIONS**
SPALTACHSENSTUFENGESTALTUNG FÜR HALBLEITERANWENDUNGEN
CONCEPTION D'ÉTAGES À AXES SÉPARÉES POUR DES APPLICATIONS SEMI-CONDUCTRICES

(30) Priority: 27.03.2007 US 908214 P
(43) Date of publication of application: 16.12.2009
(73) Proprietor: Koninklijke Philips Electronics N.V., 5621 BA Eindhoven (NL)
(72) Inventor: VERMEULEN, Johannes Petrus Martinus Bernardus, Briarcliff Manor, NY 10510-8001 (US); PEIJNENBURG, Antonius T.A., Briarcliff Manor, NY 10510-8001 (US)
(74) Representative: Kroeze, Johannes Antonius
(86) International application number: PCT/IB2008/051006
(87) International publication number: WO 2008/117197

(56) References cited:
- EP-A- 0 917 004
- US-A1- 2004 012 768
- US-A1- 2004 160 586

## Description

This disclosure relates to positioning equipment and more particularly to an apparatus and method having split axes of motion for independent control.

Many applications require the displacement and rotation of objects to provide alignment, take measurements or assemble components. These applications may include high precision translation and rotation stages to complete needed operations. One such application includes, for example, semiconductor processing, measurements and/or inspection. For the positioning of semiconductor substrates, such as semiconductor wafers, relative to a certain process, planar positioning systems (stages) may be used. Numerous solutions for planar motion systems have been provided, either by simply stacking up two linear stages (X and Y) on top of each other (e.g., in the vertical plane), by stacking three linear axes (X1, X2 and Y) in an H-drive configuration (e.g., in the horizontal plane), or alternatively via true planar (X-Y) actuation. Different kinds of actuation systems have been used, varying from electromagnetic actuators (Lorentz-based or based on variable reluctance forces) to piezoelectric actuators.

Especially for high precision and high throughput applications, e.g., in the semiconductor industry (both inspection and lithography tools), a planar motion system (either stacked linear or true planar motion systems) for positioning the wafer relative to other machine parts, has particular drawbacks from the actuation and metrology point of view. To bring down disturbance forces associated with stage accelerations to a level that is acceptable from a position uncertainty point of view, the interaction between the stage and other machine parts needs to be minimized, e.g., by using frame motion compensation techniques, or additional force-frames or balance masses. For planar stages (either stacked linear or true planar systems), decoupling the acceleration forces from the stage assembly is difficult since in addition to pure forces in X and Y directions, moments in Rz are also involved.

In addition to the decoupling of acceleration forces, stage metrology is difficult for planar motion systems, particularly in the vertical (Z) direction. To work around existing solutions on distance measuring interferometer (DMI) systems for measuring the vertical position (height) and displacement of a stage (by means of an extra measuring e.g. at 45°), a large reference plate (e.g., mirror) is needed which is at least as large as the stage stroke in the horizontal plane (X, Y). Apart from the fact that mounting such a reference mirror at sufficiently high eigenfrequency is not trivial, the volume needed by the reference mirror is essentially not available and taken up by other machine parts.

Alternatively, differential DMI systems may be used which measure a first stage's vertical position (height) relative to the fixed world (machine base) through an optical element on a second stage, which carries the first stage (stacked linear axes). In this case, the uncertainty in the position of the first, upper stage (which carries the wafer) as a result of displacement, rotation and deformation of the second, lower stage, may easily exceed several tens or even hundreds of nanometers. The same holds for other options, such as using cotraveling interferometers on separate air bearings (decoupled in vertical direction). The stage uncertainty after calibration of DMI mirrors and air bearing guides still is in the order tens of nanometers. This is mainly as the result of air bearing noise.

Another drawback of stacked planar positioning systems (either two linear stages on top of each other, or three linear axes stacked in an H-drive configuration) is that by stacking up two axes (stages), the mass of the second, lower stage, carrying or positioning the first, upper stage (which carries the wafer in this case), will typically be about a factor of 2-3 times higher than the mass of the first, upper stage. Consequently, it will become more and more difficult to reach the necessary targets for high eigenfrequencies and associated control bandwidth for a stacked system.

EP 0 917 004 discloses a stage system and exposure apparatus having a first stage movable along a reference plane, a second stage movable along a second direction intersecting the reference plane, and first and second driving means for first stage and second stage, a countermass, and a third driving mechanism.

US 2004/0012768 discloses a stage assembly for moving and positioning a device including a stage base, a stage, a stage mover assembly, a reactive mass assembly, a reactive mover assembly, and a control system.

US 2004/0160586 disclose an exposure method and apparatus with vibration-preventive control including columns installed on a base plate, a reticle base supported inside the columns with variable mount sections having high rigidity, a finely movable stage on the reticle base, and a coarsely movable stage hung on the bottom of a support plate over the reticle base.

EP 2 003 681 A1, which forms state of the art in accordance with Article 54(3) EPC, discloses a measuring device and method. The measuring device comprises a reticle stage, a wafer stage and a measurement stage. Position information of a movable body within an XY plane is measured with high accuracy by an encoder system whose measurement values have favorable short-term stability. Further, position information of the movable body in a Z-axis direction is measured with high accuracy by a surface position measuring system. The encoder system and the surface position measuring system directly measure the upper surface of the movable body.

In accordance with the present principles, a stage assembly includes a first stage, carrying the substrate, having at least one degree of freedom and being movably mounted in a first stage base frame, the first stage base frame permitting motion in a first direction. A second stage having at least one degree of freedom and being movably mounted in a second stage base frame. The second stage base frame permits motion in a second direction, which is different from the first direction. An isolated metrology reference frame is configured to provide a point of reference for the first and second stages. The stage assembly is characterized in that the first stage and the second stage are independently movable and mechanically decoupled from each other, and the first stage and second stage are disposed one over the other in a third direction which is orthogonal to the first and second directions of motion. In an alternate embodiment, the first stage serves as a metrology reference in one or more degrees of freedom (DoF) for the second stage and vice versa, such that a relative measurement between stages is created.

These and other objects, features and advantages of the present disclosure will become apparent from the following detailed description of illustrative embodiments thereof, which is to be read in connection with the accompanying drawings.

This disclosure will present in detail the following description of preferred embodiments with reference to the following figures wherein:
FIG. 1 is a view of a first stage assembly used as a component of a split axes stage assembly of FIG. 3.
FIG. 2 is a view of a second stage assembly used as a component of the split axes stage assembly of FIG. 3.
FIG. 3 is a view of the first stage assembly of FIG. 1 with the second stage of FIG. 2 located over the first stage in accordance with one embodiment;
FIG. 4 is a view of a first stage assembly, for which the second stage serves as a metrology reference in one or several DoF for relative measurement in X, the first stage being used as a component of a split axes stage assembly of FIG. 6;
FIG. 5 is a view of a second stage assembly, for which the first stage serves as a metrology reference in one or several DoF for relative measurements in Y, the second stage being used as a component of a split axes stage assembly of FIG. 6; and
FIG. 6 is a view of the first stage assembly of FIG. 4 with the second stage of FIG. 5 located over the first stage in accordance with another embodiment.

The present disclosure describes systems and methods for positioning objects such as semiconductor substrates or wafers, relative to other machine parts in semiconductor applications. Planar motion systems (e.g., stacked linear or true planar motion systems) have particular drawbacks from an actuation and metrology point of view, especially at high precision and high throughput. In accordance with embodiments of the present invention, stages are employed with split up axes of motion. X and Y long stroke motion is attributed to two independent, approximately orthogonal stage modules in the machine. Here, only two separate strip-shaped reference surfaces (e.g., metal flats or DMI mirrors as metrology references) are needed for measuring a vertical position of the two separate stages independently, which is typically less (e.g., one order of magnitude difference) critical compared to the horizontal positions. In addition, the moving mass(es) in the system will be significantly smaller, and as a consequence, the associated vibration bandwidth tolerance can be essentially higher. Smaller moving mass in a split axes design in accordance with the present principles is provided compared to a conventional planar stage where a second lower stage needs to carry and drive a first upper stage (which usually carries the wafer or other object). To provide favorable dynamic behavior, the mass ratio of the two stages may be in the order of 1:2 to 1:3.

Consequently, the decoupling of acceleration forces and stage metrology in the vertical (Z) direction becomes easier to deal with in accordance with the present principles, where the stages are separated. The split axes concept may generally be applied in semiconductor applications, such as, but not limited to nano-imprint lithography, E-beam inspection, microscopy, and materials research.

It should be understood that the present invention will be described in terms of semiconductor applications; however, the teachings of the present invention are much broader and are applicable to any application or system where alignment or positioning of components is needed, such as biomedical applications. Such applications or systems may include optical systems for positioning lasers or optical equipment, splicing systems, manufacturing metrology systems, etc.

Throughout the FIGS. the following convention will be used to indicate coordinates. Labels XA1, XA2, XB1, XB2, YA1-3, YB1-3, ZA1, ZB1, etc. are employed to designate coordinates of a metrology system. The indices A and B refer to a respective stage A and B. X, Y and Z represent the respective direction. Furthermore, the orientation of the stages is determined from, e.g., two or more DMI beams at a distance, e.g., RZA is determined by YA1 and YA3). These beams or positions are labeled with numbers 1-3. So in one example, YA1 represent a Y-direction stage A measurement from beam or position 1.

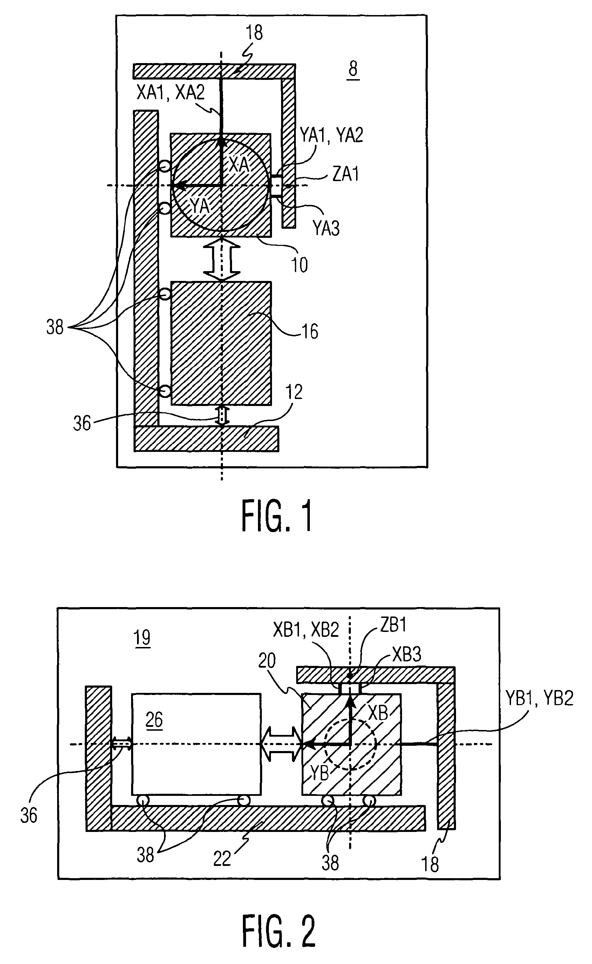

Referring now to the drawings in which like numerals represent the same or similar elements and initially to FIG. 1, a stage assembly 8 includes a stage 10, referred to as stage A (STA), which is guided by a base frame (BF) 12 to restrict motion. A balance mass (BMA) 16 may be used for decoupling acceleration reaction forces from the stage 10 to the base frame (BF) 12. Also included is a separate isolated metrology frame (MF) 18 for separately measuring relative stage position (X, Y, Z) and orientation (Rx, Ry, Rz) for stage 10. Metrology frame 18 may include, e.g., strip-shaped reference surfaces (e.g. metal flats or DMI mirrors). In this embodiment, stage 10 is permitted to move over a long stroke in the direction of X.

Referring now to FIG. 2, a stage assembly 19 includes a wafer stage 20, referred to as stage B (STB), which is guided by a base frame (BF) 22 to restrict motion. A balance mass (BMB) 26 may be used for decoupling acceleration reaction forces from the stage 20 to the base frame (BF) 22. The isolated metrology frame (MF) 18 is the same metrology frame 18 employed for stage 10 (STA) and is used for measuring relative stage position (X, Y, Z) and orientation (Rx, Ry, Rz) for stage 20 separately from stage 10. In this embodiment, stage 20 is permitted to move over a long stroke in the direction of Y.

It should be understood that for high-end applications, the stages 10 and 20 are driven relative to the balance masses 16 and 26. The balance masses 16 and 26 may be actuated by drift actuators or guided by flexure mechanisms 36 in combination with dampers for energy dissipation relative to the base 12, 22. Guides 38 for the stages 10, 20 are preferably active (active magnetic bearings) to be able to decouple the stages 10, 20 from the base 12, 22 in all degrees of freedom and provide a reference to the isolated metrology frame 18 by means of sensors, such as DMI systems. Guides 38 may be employed on masses 16, 26 as well, although alternate mechanisms may be employed.

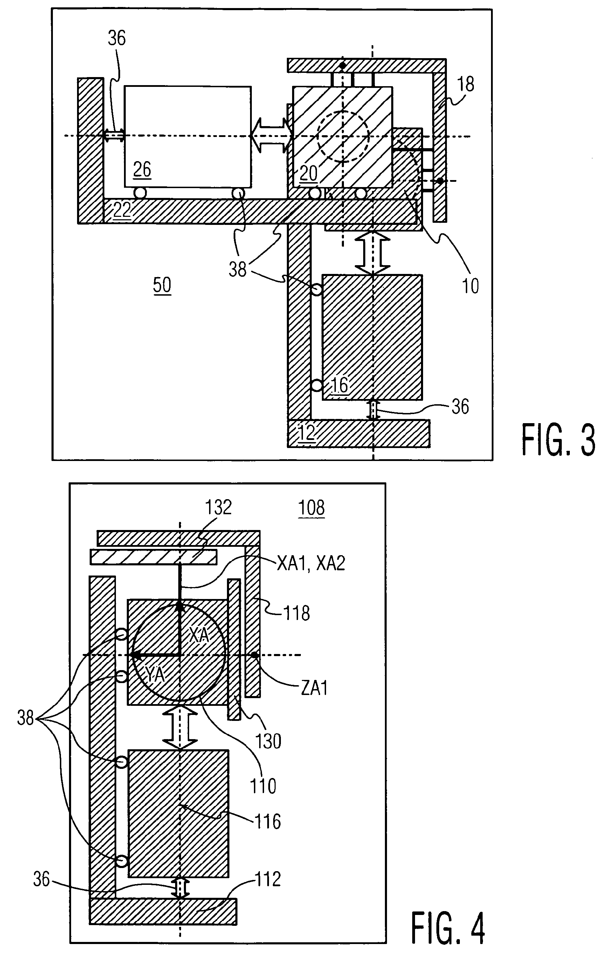

Referring to FIG. 3, a split axes stage assembly 50 includes stage assemblies 8 and 19 that include stages 10 and 20 respectively, arranged in a transverse orientation relative to one another. In one embodiment, stages 10 and 20 have their axes of motion arranged substantially orthogonal to each other. Since separate balance masses 16 and 26 are applied for each stage, the base frames 12 and 22 may be combined in a joint frame or be completely or partially isolated from one another. Stage 20 may be associated with a particular application or process, and may include or carry a wafer, a mask, an inspection tool or a lithography tool or device. Stage 20 may be located over stage 10. Other configurations and orientations may be employed including non-orthogonal arrangements between assemblies 8 and 19. The isolated metrology frame 18 may be used for measuring the relative position and orientation of stage 10 and stage 20 individually.

In one embodiment, each of stages 10 and 20 take a measurement against the metrology frame 18 in the X, Y and Z axes and about the X, Y and Z axes (referred to as the Rx, Ry and Rz DoF). These local measurements can be used to find a relative displacement and orientation between the positions of stages 10 and 20. Advantageously, each stage is mechanically decoupled or isolated such that each stage can handle the accelerations or disturbances from the other stage.

In one embodiment, the base frames 12 and 22 can be connected into a single machine base (not shown). The balance mass 16, 26 (mass ratio, e.g., 1:10) acts as a filter for reaction forces of the stages 10, 20, such that residual forces to the base 12 or 22 are acceptable. The machine base is isolated through a pedestal (not shown, e.g., an isolated floor slab), and metrology frames 18 are isolated through separate (active) vibration isolation systems (e.g., air mounts).

FIG. 3 shows a split axes stage design using the isolated metrology frame 18 for measuring relative stage position (X, Y, Z) and orientation (Rx, Ry, Rz) for each stage separately. Relative motion between the stages is determined by combining the metrology information of the two individual stages.

FIGS. 4-6 are directed to an alternate embodiment, where direct metrology is employed between two stages for all in-plane measurements (X, Y, Rx, Ry, Rz), combined with a separate metrology frame for the vertical degree of freedom (Z).

Referring to FIG. 4, a stage assembly 108 includes a wafer stage 110, referred to as stage A (STA), which is guided by a base frame (BF) 112 to restrict motion. A balance mass (BMA) 116 may be used for decoupling acceleration reaction forces from the stage 110 base frame (BF) 112. Also included is a separate isolated metrology frame (MF) 118, which is equivalent to MF 18, for measuring relative stage position (Z) for stage 110 separately. In this embodiment, stage 110 is permitted to move over a long stroke in the direction of X.

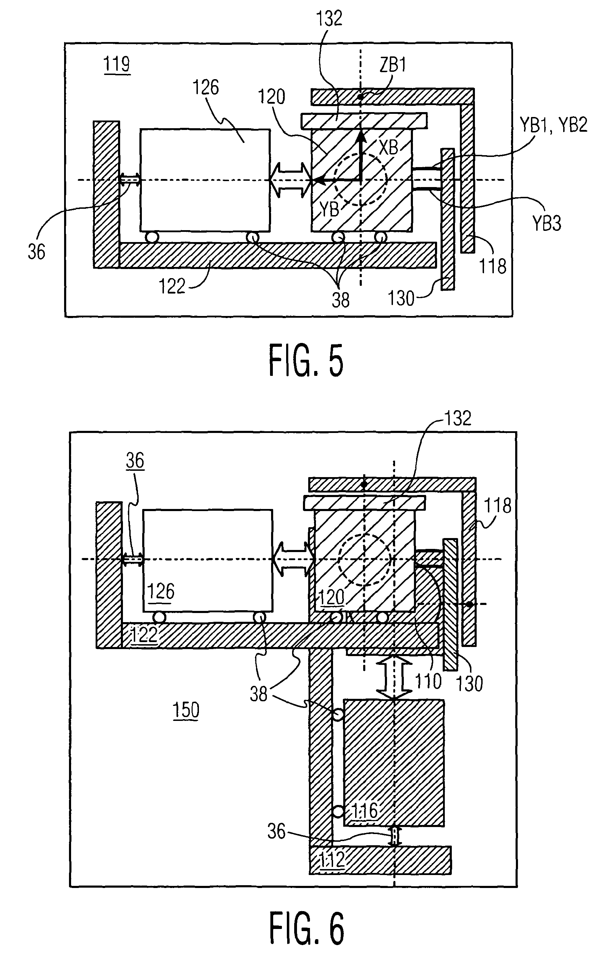

A metrology reference A 130 and metrology reference B 132 are employed on stage A 110 and stage B 120 (see FIG. 6) respectively, for direct metrology between the two stages for all in-plane measurements (X, Y, Rx, Ry, Rz), combined with a separate metrology frame 118 for the vertical degree of freedom (Z) of stages 110 and 120.

Referring now to FIG. 5, a stage assembly 119 includes a wafer stage 120, referred to as stage B (STB) 120, which is guided by a base frame (BF) 122 to restrict motion. A balance mass (BMB) 126 may be used for decoupling acceleration reaction forces from the stage 120 to the base frame (BF) 122. The isolated metrology frame (MF) 118 is the same metrology frame 118 employed for stage 110 (STA) and is used for measuring relative stage position (Z) for stage 120 separately from stage 110. In this embodiment, stage 120 is permitted to move over a long stroke in the direction of Y.

Reference B 132 is depicted in FIG. 4 for reference only, and reference A 130 is depicted in FIG. 5 for reference only. Stage A 110 includes reference A 130, and stage B 120 includes reference B 132. Metrology reference A 130 and metrology reference B 132 are employed for direct metrology between the two stages for all in-plane measurements (X, Y, Rx, Ry, Rz), combined with a separate metrology frame 118 for the vertical degree of freedom (Z). Metrology reference 132 in FIG. 5 is the same as the metrology reference 132 in FIG. 4 and metrology reference 130 in FIG. 5 is the same as metrology reference 130 in FIG. 4.

Referring to FIG. 6, a split axes stage assembly 150 includes stage assemblies 108 and 119 which include stages 110 and 120 respectively, arranged in a transverse orientation relative to one another. In one embodiment, stages 110 and 120 have their axes of motion arranged substantially orthogonal to each other. Since separate balance masses 116 and 126 are applied for each stage, the base frames 112 and 122 may be combined in a joint frame or isolated or partially isolated from one another. Stage 120 may be associated with a particular application or process, such as a wafer or mask inspection or lithography device or tool. Stage 120 may be located over stage 110 although other configurations may be employed. Stages 110 and 120 are preferably mechanically independent (and may be decoupled) from one another.

Stages 110 and 120, like stages 10 and 20, are may be mechanically decoupled such that acceleration reaction forces from the respective stages to the base frame(s) are handled along one primary direction (the primary direction of motion of the stage) preferably using a balance mass disposed in the primary direction. While balance masses are preferred, other components may be employed such as force frames, dampers, etc. By separating the X motion in the first stage with the Y motion in the second stage, better force decoupling can be achieved by means of separate balance masses for each stage attributed to the associated degree of freedom.

In one embodiment, each of stages 110 and 120 takes a measurement against the metrology frame 118 in the Z axis. In addition, X and Y local measurements are made for each stage using the metrology references B 132 for stage A 110 and using the metrology references A 130 for stage B 120. These measurements provide the relative displacement and rotation between the positions of stages 110 and 120.

In one embodiment, the base frames 112 and 122 can be connected into a single machine base (not shown). The balance mass(es) 116, 126 (mass ratio e.g. 1:10) act as a filter for reaction forces of the stages 110, 120, such that residual forces to the base 112 or 122 are made acceptable or controlled. The machine base may be isolated through a pedestal (e.g., an isolated floor slab), and metrology frames 118 are isolated through separate (active) vibration isolation systems (e.g., air mounts).

One application, in accordance with present embodiments, includes use in a nano-imprint lithography (nil) setup. Here, a template with e.g., a 1:1 (negative) image of the pattern is imprinted in resist on a semiconductor wafer. One of the advantages of nil, compared to optical lithography, is the absence of projection optics, which makes the application of separate (split axes) stages highly advantageous (see below).

The split axes concept may generally be applied in semiconductor applications, such as, but not limited to nano-imprint lithography, E-beam inspection, microscopy, and materials research. In such applications, the first stage or stage A is employed to support a platen or a semiconductor wafer to be processed. The second stage or stage B may be employed to position an inspection tool, a lithographic mask, a laser or other tool or device. The positions and orientations of the stages will be monitored by a high-end metrology system, such as DMI or a grating system to ensure proper alignment (X, Y, Rz), leveling (Rx, Ry) and vertical position (Z).

Applying the split axes concept is not obvious for each different application.

For optical lithography systems for example, a split axis design would imply a lateral motion of the projection optics system (lens or mirror assembly), which is not trivial since the optics are used for the actual imaging. For nano-imprint lithography applications, however, such as S-FIL (step and flash imprint lithography) and hot embossing, projection optics are not present, and therefore, a split-axes design through lateral motion of the imprint head orthogonal to the wafer can actually be highly advantageous. Here, lateral motion of optics is needed only for curing the resin, which is not as accurate and time-critical as it is for projection optics in optical lithography systems, and so it can be coupled as a slave to the imprint head motion on a separate guide way in a rather compliant way.

In interpreting the appended claims, it should be understood that:
a) the word "comprising" does not exclude the presence of other elements or acts than those listed in a given claim;
b) the word "a" or "an" preceding an element does not exclude the presence of a plurality of such elements;
c) any reference signs in the claims do not limit their scope;
d) several "means" may be represented by the same item or hardware or software implemented structure or function; and
e) no specific sequence of acts is intended to be required unless specifically indicated.

Having described preferred embodiments for split axes stage design for semiconductor applications (which are intended to be illustrative and not limiting), it is noted that modifications and variations can be made by persons skilled in the art in light of the above teachings.

Having thus described the details and particularity required by the patent laws, what is claimed and desired protected by Letters Patent is set forth in the appended claims.

## Claims

1. A stage assembly, comprising:
a first stage (10, 110) having at least one degree of freedom and being movably mounted in a first stage base frame (12, 112), the first stage base frame permitting motion in a first direction; and
a second stage (20, 120) having at least one degree of freedom and being movably mounted in a second stage base frame (22, 122), the second stage base frame permitting motion in a second direction which is different from the first direction;
**characterized by**
an isolated metrology reference frame (18, 118) configured to provide a point of reference for the first and second stages, and
in that the first stage and the second stage being independently movable and mechanically decoupled from each other and the first stage and second stage being disposed one over the other in a third direction which is orthogonal to the first and second directions of motion.

2. The stage assembly as recited in claim 1, wherein the first stage and the second stage each include a balance mass (16, 26, 116, 126) to decouple acceleration reaction forces of the stages to their respective stage base frames.

3. The stage assembly as recited in claim 1, wherein the first direction (X) and the second direction (Y) are arranged in a substantially orthogonal orientation.

4. The stage assembly as recited in claim 1, wherein the reference metrology frame (18) provides a reference to determine an independent position and orientation for each of the first stage and the second stage, and the independent positions of the first stage and the second stage are employed to determine relative positions and orientations between the first stage and the second stage.

5. The stage assembly as recited in claim 1, wherein the first stage (10) provides at least one degree of freedom with at least one long stroke motion capability relative to a respective stage base frame (12, 112).

6. The stage assembly as recited in claim 1, wherein the second stage (20; 120) provides at least one degree of freedom with at least one long stroke motion capability relative to a respective stage base frame (22, 122).

7. The stage assembly as recited in claim 1, comprising a first reference metrology frame (130) configured to provide a point of reference for local position and orientation changes of the first and second stages.

8. The stage assembly as recited in claim 7, wherein the first direction and the second direction are arranged in a non-orthogonal orientation.

9. The stage assembly as recited in claim 7, further comprising a second reference metrology frame (132) configured to provide a point of reference for local position and orientation changes of the first and second stages.

## Patentansprüche

1. Stufenanordnung mit:
einer ersten Stufe (10, 110), die mindestens einen Freiheitsgrad aufweist und in einem Grundrahmen (12, 112) der ersten Stufe bewegbar angebracht ist, wobei der Grundrahmen der ersten Stufe eine Bewegung in einer ersten Richtung erlaubt; sowie
einer zweiten Stufe (20, 120), die mindestens einen Freiheitsgrad aufweist und in einem Grundrahmen (22, 122) der zweiten Stufe bewegbar angebracht ist, wobei der Grundrahmen der zweiten Stufe eine Bewegung in einer zweiten Richtung erlaubt, die sich von der ersten Richtung unterscheidet;
**dadurch gekennzeichnet, dass**
ein isolierter Referenzmessrahmen (Reference Metrology Frame) (18, 118) vorgesehen ist, der so konfiguriert ist, dass er einen Referenzpunkt für die erste und zweite Stufe vorsieht; und
die erste und zweite Stufe unabhängig voneinander bewegbar und mechanisch voneinander entkoppelt sind und die erste und zweite Stufe übereinander in einer dritten Richtung, die orthogonal zu der ersten und zweiten Bewegungsrichtung verläuft, angeordnet sind.

2. Stufenanordnung nach Anspruch 1, wobei die erste Stufe und die zweite Stufe jeweils eine Ausgleichsmasse (16, 26, 116, 126) aufweisen, um Beschleunigungsreaktionskräfte der Stufen zu ihren jeweiligen Stufengrundrahmen zu entkoppeln.

3. Stufenanordnung nach Anspruch 1, wobei die erste Richtung (X) und die zweite Richtung (Y) in einer im Wesentlichen orthogonalen Ausrichtung angeordnet sind.

4. Stufenanordnung nach Anspruch 1, wobei der Referenzmessrahmen (18) eine Referenz vorsieht, um eine unabhängige Position und Ausrichtung für sowohl die erste als auch die zweite Stufe zu ermitteln, und wobei die unabhängigen Positionen der ersten Stufe und der zweiten Stufe eingesetzt werden, um relative Positionen und Ausrichtungen zwischen der ersten Stufe und der zweiten Stufe zu ermitteln.

5. Stufenanordnung nach Anspruch 1, wobei die erste Stufe (10) mindestens einen Freiheitsgrad mit mindestens einer Langhubbewegungsfähigkeit relativ zu einem jeweiligen Stufengrundrahmen (12, 112) vorsieht.

6. Stufenanordnung nach Anspruch 1, wobei die zweite Stufe (20; 120) mindestens einen Freiheitsgrad mit mindestens einer Langhubbewegungsfähigkeit relativ zu einem jeweiligen Stufengrundrahmen (22, 122) vorsieht.

7. Stufenanordnung nach Anspruch 1, mit einem ersten Referenzmessrahmen (130), der so konfiguriert ist, dass er einen Referenzpunkt für Lokalpositions- und Ausrichtungsänderungen der ersten und zweiten Stufe vorsieht.

8. Stufenanordnung nach Anspruch 7, wobei die erste Richtung und die zweite Richtung in einer nicht-orthogonalen Ausrichtung vorgesehen sind.

9. Stufenanordnung nach Anspruch 7, die weiterhin einen zweiten Referenzmessrahmen (132) umfasst, der so konfiguriert ist, dass er einen Referenzpunkt für Lokalpositions- und Ausrichtungsänderungen der ersten und zweiten Stufe vorsieht.

## Revendications

1. Ensemble d'étages comprenant :
un premier étage (10, 110) ayant au moins un degré de liberté et monté de façon mobile dans un premier châssis de base d'étage (12, 112), le premier châssis de base d'étage permettant un mouvement dans une première direction ; et
un deuxième étage (20, 120) ayant au moins un degré de liberté et monté de façon mobile dans un deuxième châssis de base d'étage (22, 122), le deuxième châssis de base d'étage permettant un mouvement dans une deuxième direction différente de la première direction ;
**caractérisé par**
un châssis de référence de métrologie isolé (18, 118) configuré pour fournir un point de référence aux premier et deuxième étages, et
en ce que le premier étage et le deuxième étage sont indépendamment mobiles et mécaniquement découplés l'un de l'autre et le premier étage et deuxième étage sont agencés l'un au-dessus de l'autre dans une troisième direction qui est orthogonale aux première et deuxième directions de mouvement.

2. Ensemble d'étages selon la revendication 1, dans lequel le premier étage et le deuxième étage comprennent chacun une masse d'équilibrage (16, 26, 116, 126) pour découpler les forces de réaction d'accélération des étages sur leurs châssis de base d'étage respectif.

3. Ensemble d'étages selon la revendication 1, dans lequel la première direction (X) et la deuxième direction (Y) sont agencées dans une orientation sensiblement orthogonale.

4. Ensemble d'étages selon la revendication 1, dans lequel le châssis de métrologie de référence (18) fournit une référence pour déterminer une position et orientation indépendantes pour chacun des premier étage et deuxième étage, et les postions indépendantes du premier étage et du deuxième étage sont employées pour déterminer des positions et orientations relatives entre le premier étage et le deuxième étage.

5. Ensemble d'étages selon la revendication 1, dans lequel le premier étage (10) fournit au moins un degré de liberté avec au moins une capacité de mouvement de course longue par rapport à un châssis de base d'étage respectif (12, 112).

6. Ensemble d'étages selon la revendication 1, dans lequel le deuxième étage (20, 120) fournit au moins un degré de liberté avec au moins une capacité de mouvement de course longue par rapport à un châssis de base d'étage respectif (22, 122).

7. Ensemble d'étages selon la revendication 1, comprenant un premier châssis de métrologie de référence (130) configuré pour fournir un point de référence pour la position locale et les changements d'orientation des premier et deuxième étages.

8. Ensemble d'étages selon la revendication 7, dans lequel la première direction et la deuxième direction sont agencées dans une orientation non-orthogonale.

9. Ensemble d'étages selon la revendication 7, comprenant en outre un deuxième châssis de métrologie de référence (132) configuré pour fournir un point de référence pour la position locale et les changements d'orientation des premier et deuxième étages.
